# EUROPÄISCHE PATENTSCHRIFT

(11) **EP 0 362 783 B1**
(45) Veröffentlichungstag und Bekanntmachung des Hinweises auf die Patenterteilung: **12.01.1994**
(21) Anmeldenummer: 89118288.3
(22) Anmeldetag: 03.10.1989
(51) Int. Cl.: H03H 17/06

(54) **Filter**
Filter
Filtre

(30) Priorität: 07.10.1988 DE 3834188
(43) Veröffentlichungstag der Anmeldung: 11.04.1990
(73) Patentinhaber: Deutsche Thomson-Brandt GmbH, 78003 Villingen-Schwenningen (DE)
(72) Erfinder: Spille, Jens, Dipl.-Ing., D-3005 Hemmingen 1 (DE)
(74) Vertreter: Einsel, Robert, Dipl.-Ing.

(56) Entgegenhaltungen:
- EUROPEAN CONFERENCE ON SPEECH TECHNOLOGY, Edinburgh, September 1987, vol. 2, Seiten 193-196; L. GÜNDEL: "Aliasing in QMF-bank systems with signal modifications between analysis and synthesis"
- TELECOMMUNICATION & RADIO ENG., Band 32/33, Nr. 5, Mai 1978, Seiten 7-12, Scripta Publishing Co., Washington, US; L.M. GOLDENBERG et al.: "Separation of channels from a baseband digital signal in a pulse code modulation frequency-division system"

## Beschreibung

Die Erfindung betrifft ein Filter nach dem Oberbegriff des Anspruchs 1.

Filter der eingangs genannten Art werden verwendet um Filterbänke für sogenannte Teilbanddecoder für Audio- und Videosignale aufzubauen. Solche Filter umfassen eine Split-Filteranordnung aus einem Tiefpaßfilter und einem spiegelbildlichen Hochpaßfilter mit jeweils einem Abtastratenhalbierer sowie eine Merge-Filteranordnung aus zwei Abtastratenverdopplern mit einem Tiefpaßfilter und einem spiegelbildlichen Hochpaßfilter zur Interpolation. Die Filter sind so aufgebaut, daß keine Fehler durch die Abtastratenreduzierung auftreten, wenn die Tiefpaß- und Hochpaßübertragung fehlerfrei ist. Solche Filter sind z.B. Quadrature-Mirror-Filter, Conjugate-Quadrature-Filter nicht rekursive Wellendigitalfilter oder Lattice-Quadrature-Mirrorfilter sowie Brücken-Wellendigitalfilter.

Werden diese Filter zur Erzeugung von Teilbändern mehrstufig aufgebaut, so können Störungen auf dem Übertragungswege, wie sie z.B. durch Quantisierungsrauschen oder Datenreduktion hervorgerufen werden, zu Fehlern in unmittelbar angrenzenden oder weiter benachbarten Bändern, das heißt übernächsten Bändern führen, die sich bei der Anwendung in einem Teilbandcodierer dann als hör- oder sichtbare, nicht verdeckte Verzerrungen äußern.

Der Erfindung liegt die Aufgabe zugrunde, ein Filter der eingangs genannten Art so zu bemessen, daß Störungen in weiter benachbarten Bändern als denjenigen, in denen die Störungen auftreten, unterdrückt werden.

Diese Aufgabe wird bei einem Filter nach dem Oberbegriff des Anspruchs 1 durch die im kennzeichnenden Teil angegebenen Merkmale gelöst. Die Erfindung wird an Hand der Zeichnung erläutert.

Die Zeichnung zeigt in
- Fig. 1: eine Prinzipdarstellung eines Zwei-Band-Filters,
- Fig. 2: ein Teilfilter in einer zweistufigen Filterstruktur,
- Fig. 3: den Amplitudenfrequenzgang eines Tiefpaßfilters mit Durchlaß, Übergangs- und Sperrbereich,
- Fig. 4: die Amplitudenfrequenzgänge der beiden Stufen N1′ und N2′ aus Fig. 2 bei einer ersten Filterauslegung mit Darstellung von Störsignalen und
- Fig. 5: die Amplitudenfrequenzgänge der beiden Stufen N1′ und N2′ aus Fig. 2 bei einer erfindungsgemäßen Auslegung der Filteranordnung mit Darstellung von Störsignalen.

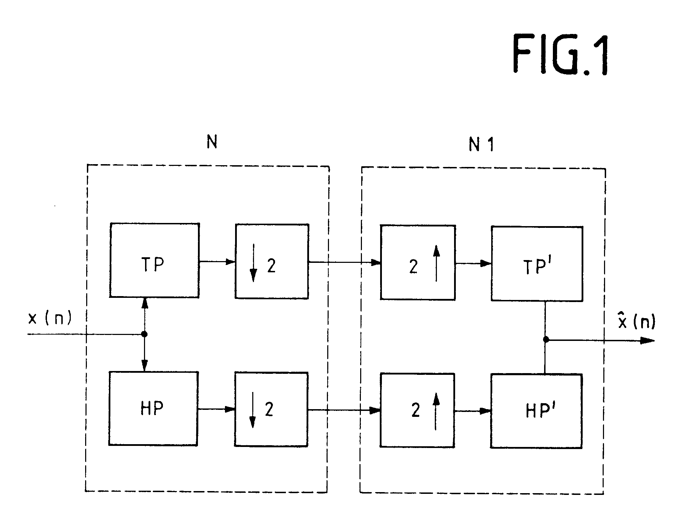

Fig. 1 zeigt eine Prinzipdarstellung eines Zwei-Band-Filters. Dieses umfaßt einen Eingang, an den digitale Signale x(n) angelegt werden, die zu einem Tiefpaßfilter TP und zu einem Hochpaßfilter HP gelangen. Das Tiefpaßfilter TP und das Hochpaßfilter HP bilden eine komplementäre Filteranordnung. An das Tiefpaßfilter TP und das Hochpaßfilter HP der Filteranordnung schließen sich jeweils Abtastratenhalbierer an. Am Ausgang der Abtastratenhalbierer treten tiefpaß- und hochpaßgefilterte Signale auf.

An diesen Schaltungspunkten könnte ein Coder angeschlossen werden mit dem eine Datenreduktion oder eine Quantisierung durchführbar ist. Dem Coder würde sich ein Decoder anschließen, dessen Ausgangssignale von den Eingangssignalen des Coders abweichen. Ersatzweise kann man sich auch vorstellen das Signale einer Störquelle überlagert sind.

Die Ausgangssignale des Decoders gelangen zu Abtastratenverdopplern. Deren Ausgangssignale werden einer zweiten Filteranordnung aus einem Tiefpaßfilter TP′ und einem Hochpaßfilter HP′ zugeführt. Durch Addition der Filterausgangssignale ergibt sich das an der Ausgangsklemme abgreifbare Ausgangssignal x̂(n).

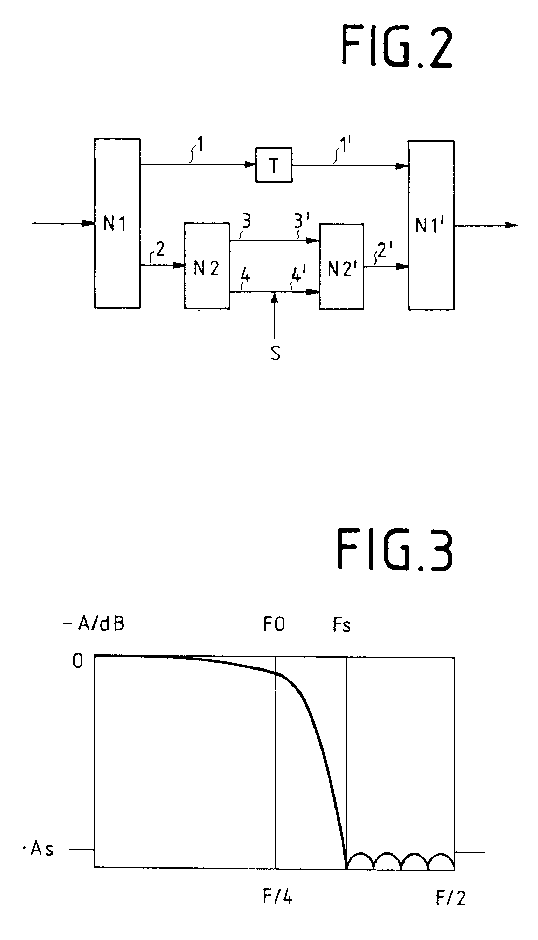

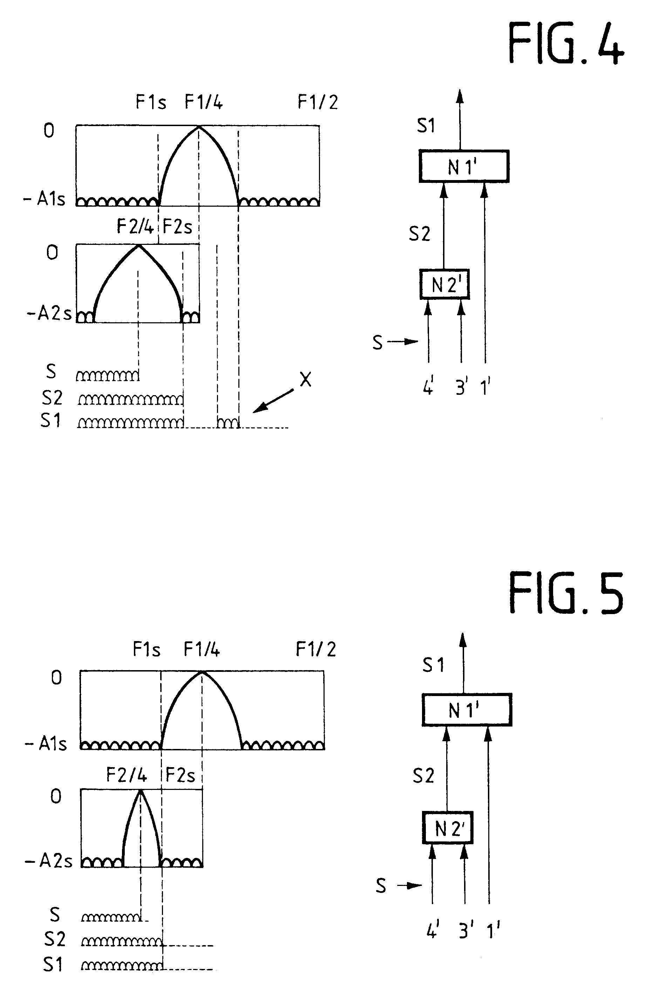

Fig. 2 zeigt als Beispiel eine zweistufige Filterstruktur, wie sie in den weiteren Figuren 4 und 5 der Darstellung des Amplitudenfrequenzganges zugrunde liegt. Sie umfaßt eine erste Stufe N1, eine zweite Stufe N2 auf der Split-Filterseite sowie eine zweite Stufe N2′ und eine erste Stufe N1′ auf der Merge-Filterseite. Zum Laufzeitausgleich dient ein Zeitverzögerungsglied T. Die Zweige, in denen die Signale auftreten, sind mit 1, 2, 3 und 4 auf der Split-Filterseite und mit 1′, 2′, 3′ und 4′ auf der Merge-Filterseite bezeichnet. Im Filterzweig 4 wird ein Störsignal S eingespeist, das zum Beispiel Quantisierungsrauschen sein kann.

In Fig. 3 ist der Amplitudenfrequenzgang eines Tiefpaßfilter mit Durchlaß-, Übergangs-und Sperrbereich dargestellt. In dieser Darstellung bedeutet As die Sperrbanddämpfung, FO die Grenzfrequenz und FS die Sperrbandeckfrequenz. Das Sperrband erstreckt sich von FS bis F½, der Übergangsbereich von FO bis FS und der Durchlaßbereich von 0 bis F¼.

Fig. 4 zeigt eine zweistufige Merge-Filterstruktur, dessen Eingangssignale 1′ und 3′ fehlerfrei sind, und dessen Eingangssignal 4′ mit einem Störsignal S überlagert ist. Links neben den dargestellten Filterstrukturen sind die Amplitudenfrequenzgänge der Filter gezeichnet. Darunter ist die Frequenzverteilung des Störsignals S, S2, S1 auf die einzelnen Stufen gezeichnet und zwar nur die Anteile, die größer sind als die Anteile As die aufgrund der Sperrdämpfung gespiegelt werden. Wie die Zeichnung erkennen läßt, überlappen sich die Sperrbandeckfrequenzen F1s der ersten und F2s der zweiten Filterstufe. Dies führt dazu, daß auch ein Störanteil, wie er in der Zeichnung mit X bezeichnet ist, zustande kommt. Dieser Störanteil X liegt außerhalb des von dem betreffenden Filter gefilterten Teilbandes.

In der Darstellung in Fig. 5 sind die Filter so bemessen, daß die Sperrbandeckfrequenz F1s der einen Stufe mit derjenigen F2s der anderen Stufe übereinstimmt. Wie die Frequenzverteilung der Störsignale erkennen läßt, sind zwar auch hier im Teilband Störsignale vorhanden, dagegen treten Störungen in weiter entfernten Nachbarbandern nicht auf.

## Patentansprüche

1. Filter bestehend aus wenigstens einer ersten Filteranordnung (N) aus einem komplementären Tiefpaß-Hochpaßfilter (TP,HP) zum Aufteilen des Signals in zwei Frequenzbänder und wenigstens einer weiteren Filteranordnung (N′) zum Zusammenfügen der beiden Frequenzbänder, wobei die erste Filteranordnung (N) einen Coder mit einer Abtastratenhalbierung und die zweiten Filteranordnung (N′) einen Decoder mit einer Abtastratenverdoppelung umfaßt und wobei sich die erste (N) und zweite Filteranordnung (N′) derart ergänzen, daß das Ausgangssignal (x̂(n)) dem Eingangssignal (x(n)) entspricht und die Filteranordnungen (N,N′) mehrstufig ausgebildet sind, **dadurch gekennzeichnet**, daß die Filterstufen so bemessen sind, daß sich ihre Übergangsbereiche (F0-Fs) an keiner Stelle im Frequenzbereich überlappen.

2. Filter nach Anspruch 1, **dadurch gekennzeichnet**, daß Sperrbandeckfrequenzen (Fs) der einzelnen Filterstufen gleich sind.

## Claims

1. Filter consisting of at least one first filter arrangement (N) comprising a complementary low pass, high pass filter (TP, HP) for dividing the signal into two frequency bands and at least one further filter arrangement (N') for combining the two frequency bands wherein the first filter arrangement (N) comprises a coder having half the sampling rate and the second filter arrangement (N') comprises a decoder having double the sampling rate and wherein the first (N) and the second (N') filter arrangement complement each other in such a way that the output signal (x'(n)) corresponds to the input signal (x(n)) and the filter arrangements (N, N') are built up from a plurality of stages, characterised in that, the filter stages are dimensioned such that their cross-over regions (FO - Fs) do not overlap at any point in the frequency range.

2. Filter in accordance with Claim 1, characterised in that, stop band edge frequencies (Fs) of the individual filter stages are the same.

## Revendications

1. Filtre constitué par au moins un premier dispositif de filtre (N) composé d'un filtre passe-bas/passe-haut complémentaire (TP, HP) pour répartir le signal dans deux bandes de fréquence et par au moins un autre dispositif de filtre (N') pour assembler les deux bandes de fréquence (N'), le premier dispositif de filtre (N) comprenant un codeur avec une division de la fréquence de balayage et le second dispositif de filtre (N') un décodeur avec un doublage de fréquence de balayage et le premier (N) et le second dispositif de filtre (N') se complétant de telle manière que le signal de sortie (x(n)) correspond au signal d'entrée (x(n)) et les dispositifs de filtre (N, N') sont configurés à plusieurs étages, **caractérisé en ce** que les étages des filtres sont dimensionnés de telle manière que leurs bandes de transition (FO-Fs) ne se chevauchent à aucun endroit dans la gamme des fréquences.

2. Filtre selon la revendication 1, **caractérisé en ce** que les fréquences plafond de la bande a l'état bloqué (Fs) des différents étages de filtre sont égales.
